## Europäisches Patentamt

## European Patent Office

## Office européen des brevets

(19)

(11) Veröffentlichungsnummer: **0 025 578**
B1

(12)

# EUROPÄISCHE PATENTSCHRIFT

(45) Veröffentlichungstag der Patentschrift:
11.07.84

(51) Int. Cl.³: **H 01 J 37/07,** H 04 N 3/16,
H 01 L 21/263, G 05 B 11/42

(21) Anmeldenummer: 80105369.5

(22) Anmeldetag: 08.09.80

(54) Verfahren und Vorrichtung zur Regelung eines magnetischen Ablenksystems.

(30) Priorität: 12.09.79 DE 2936911

(43) Veröffentlichungstag der Anmeldung:
25.03.81 Patentblatt 81/12

(45) Bekanntmachung des Hinweises auf die Patenterteilung:
11.07.84 Patentblatt 84/28

(84) Benannte Vertragsstaaten:
FR GB NL

(56) Entgegenhaltungen:
DE - A - 2 117 193
DE - A - 2 345 290
DE - A - 2 711 535
DE - B - 1 011 922
DE - B - 1 140 231
DE - B - 1 210 910
DE - B - 1 923 830
DE - B - 2 149 107

JOURNAL OF PHYSICS-E, Scientific Instruments, 1976,
Volume 9, London GEMPERLE, NOVAK "Application of
AC magnetic field compensation to a Scanning electron
microscope" Seiten 490-495

(73) Patentinhaber: SIEMENS AKTIENGESELLSCHAFT,
Berlin und München Wittelsbacherplatz 2,
D-8000 München 2 (DE)

(72) Erfinder: Schmitt, Reinhold, Dipl.-Ing., Senftenberger
Ring 38 a, D-1000 Berlin 26 (DE)

## Beschreibung

Die Erfindung betrifft ein Verfahren zur Regelung eines magnetischen Ablenksystems für ein korpuskularstrahloptisches Gerät, insbesondere einen Elektronenstrahlschreiber, bei dem der durch Ablenkspulen fliessende Strom gemessen und durch Vergleich mit einem Sollwert ein Regelsignal zur Nachregelung des Spulenstromes erzeugt wird. Weiterhin betrifft die Erfindung eine Vorrichtung zur Durchführung dieses Verfahrens.

Um mit einem Elektronenstrahlschreiber bei der Belichtung von Halbleiter-Wafern kurze Schreibzeiten zu erreichen, ist neben einer hohen Strahlstromdichte und schneller Datenverarbeitung ein schnelles und hochgenaues Ablenksystem für den Elektronenstrahl erforderlich. Bei der Verwendung magnetischer Ablenksysteme wird das Magnetfeld durch Messung und Regelung des Spulenstromes in Ablenkspulen festgelegt. Der Spulenstrom lässt sich mit ausreichender Genauigkeit einfach messen, um auch bei den hierbei auftretenden kleinen Magnetfeldern von einigen $10^{-4}$ Tesla die verlangte Genauigkeit der Magnetfelder von $10^{-4}$ bis $10^{-5}$ zu erreichen. Schnelle Magnetfeldänderungen werden jedoch durch Wirbelströme beeinflusst, die in umgebenden leitfähigen Bauteilen induziert werden. Unter Umständen kann daher das Magnetfeld dem Sollwert nicht schnell genug folgen. Eine Stromregelung mit zusätzlichem Differential-Verhalten ist nur so weit zulässig, als dadurch kein Überschwingen ausserhalb der erlaubten Toleranzen auftritt.

Ein Regelsystem, das auf einer unmittelbaren Messung des Magnetfeldes beruht, könnte diese Probleme umgehen. Dabei tritt jedoch die Schwierigkeit auf, kleine Magnetfelder mit der hier verlangten Genauigkeit statisch und dynamisch zu messen.

Auch die weitestgehende Verwendung von nichtleitfähigen Werkstoffen, Ferritabschirmungen und die Einhaltung möglichst grosser Abstände zu leitenden Flächen bringt nur einen bedingten Erfolg.

Der vorliegenden Erfindung liegt die Aufgabe zugrunde, ein Verfahren und eine entsprechende Vorrichtung der eingangs genannten Art derart zu erweitern, dass das Magnetfeld unabhängig von Beeinflussungen durch Wirbelströme stets schnell und exakt dem Sollwert nachgeführt wird.

Diese Aufgabe wird erfindungsgemäss durch die im kennzeichnenden Teil des Anspruches 1 angegebenen Verfahrensschritte gelöst.

Erfindungsgemäss ist hier eine kombinierte Regelung vorgeschlagen. Im statischen Fall erfolgt die Regelung über die Messung des Spulenstromes, womit sich die verlangte Genauigkeit einhalten lässt. Bei Sollwert-Änderungen überlagert sich ein zweiter Regelkreis: Mit Hilfe einer Magnetfeld-Messeinrichtung wird ein der Feldänderung dB/dt proportionales Signal erzeugt und mit der durch Differenzieren des Sollwertes x gewonnenen Sollwert-Änderung dx/dt verglichen. Folgt das Magnetfeld dem Sollwert nicht schnell genug, so entsteht eine zusätzliche Regelabweichung.

In vorteilhafter Weiterbildung der Erfindung ist vorgesehen, dass das zusätzliche Regelsignal auf die Nachregelung des Spulenstromes einwirkt. Ebenso vorteilhaft ist es jedoch auch möglich, dass das zusätzliche Regelsignal direkt auf das Magnetfeld einwirkt. Durch diese einfachen Massnahmen wird bei hoher Präzision gleichzeitig eine weitgehende Kompensation wirbelstrombedingter Verzögerungen erreicht. Die eingangs erwähnten Massnahmen zur Verbesserung des Regelverhaltens, z.B. durch Einbeziehen eines Differentialanteiles, sind auch im Rahmen des erfindungsgemässen Prinzips vorteilhaft möglich.

Bei einer Vorrichtung zur Durchführung des erfindungsgemässen Verfahrens mit einer bekannten Stromregelung ist die Lösung der genannten Aufgabe dadurch gekennzeichnet, dass eine magnetische Messeinrichtung vorgesehen ist, in der das der Feldänderung dB/dt proportionale Signal erzeugt wird, dass der Sollwert zusätzlich einer Differenzierschaltung zugeführt ist und dass die Ausgänge der Magnetfeld-Messeinrichtung und der Differenzierschaltung mit je einem Eingang eines Differenzverstärkers verbunden sind, dessen Ausgang an die Regeleinrichtung für den Spulenstrom angeschlossen sind. Ebenso vorteilhaft ist es möglich, dass der Ausgang des Differenzverstärkers an Zusatzspulen im Ablenksystem angeschlossen ist. Für die Magnetfeld-Messeinrichtung können z.B. eine Induktionsspule mit Impedanzwandler oder ein Hall-Generator mit Differenzierschaltung oder auch eine Feldplatte mit Linearisierung und Differenzierschaltung verwendet werden.

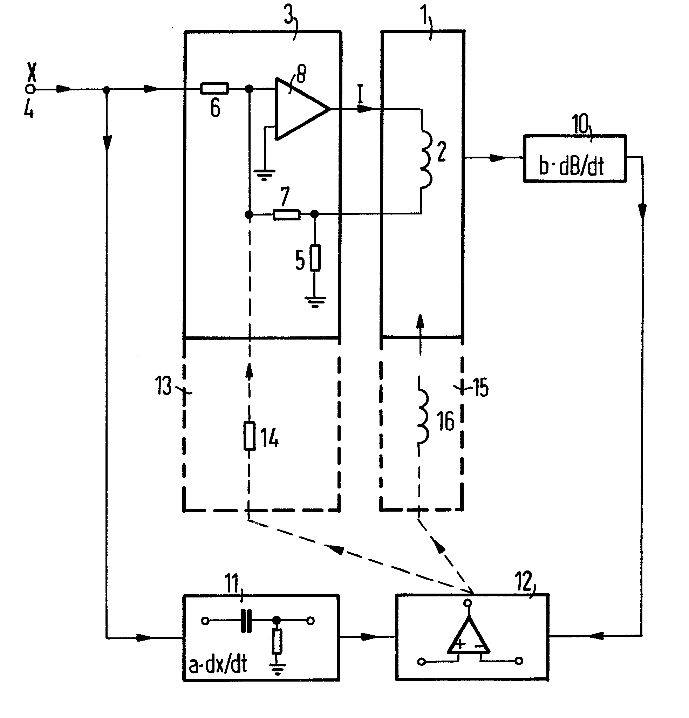

Im folgenden wird anhand einer Figur ein Ausführungsbeispiel der Erfindung näher beschrieben und erläutert. Die einzige Figur zeigt dabei ein Blockschaltbild einer Vorrichtung zur schnellen und exakten Magnetfeld-Regelung für einen Elektronenstrahlschreiber.

Die Figur zeigt stark vereinfacht ein Ablenksystem 1 mit einer einzelnen Ablenkspule 2. In der Praxis wird bei Elektronenstrahlschreibern zur Ablenkung des Elektronenstrahles in einer Koordinate mindestens ein symmetrisch zur Achse des Elektronenstrahlschreibers angeordnetes Spulenpaar, vorzugsweise jedoch zwei hintereinanderliegende Spulenpaare, eingesetzt. Das Ablenksystem 1 wird über eine Stromregelung 3 angesteuert. Der Stromregelung wird am Eingang 4 der Sollwert x zugeführt, beispielsweise über ein rechnergesteuertes Programm. In diesem Ausführungsbeispiel ist eine einfache Stromregelung angedeutet, bei der der durch die Ablenkspule 2 fliessende Strom I an einem Widerstand 5 einen Spannungsabfall gegen Erde erzeugt. Diese Spannung wird ebenso wie der Sollwert x einem mit den beiden Eingangswiderständen 6 und 7 bestückten Verstärker 8 zum Vergleich zugeführt. Für den statischen Betriebsfall reicht diese Regelung des Magnetfeldes über die Stromregelung aus, um mit der verlangten Genauigkeit das geforderte Magnetfeld einzuhalten. Bei schnellen Magnetfeld-Änderungen überlagert sich nun ein zweiter Regelkreis. Mit Hilfe einer Messeinrichtung 10, beispielsweise einer Induktionsspule mit Impedanzwandler, wird ein der Magnetfeld-Änderung proportionales Signal b · dB/dt erzeugt. Der Multiplikationsfaktor b hängt von der Art der verwendeten Messeinrichtung ab und ist notwendig, um einen Vergleich mit dem differenzierten Sollwert dx/dt zu ermöglichen. Der Sollwert x wird in einer Differenzierschaltung 11 differenziert. Es ergibt sich ein Signal a · dx/dt. a ist wiederum ein Multiplikationsfaktor, der die Art der verwendeten Differenzierschaltung berücksichtigt. Die beiden so erzeugten Signale werden einem Differenzverstärker 12 zugeführt. Falls das Magnetfeld dem Sollwert x nicht schnell genug folgt, so entsteht im Differenzverstärker eine weitere Regelabweichung, die entweder über ein Glied 13 mit einem Widerstand 14 auf den Stromregelkreis oder über ein Glied 15 mit einer Zusatzspule 16 direkt auf das Magnetfeld einwirkt.

Da jede Differenzierschaltung in der Praxis prinzipiell einen von der Frequenz abhängigen Fehler aufweist, kann es unter Umständen vorteilhaft sein, in den Zweig zwischen der Messeinrichtung 10 und dem Differenzverstärker 12 ein Korrekturglied einzuschalten, das den Fehler wieder beseitigt.

**Patentansprüche**

1. Verfahren zur Regelung eines magnetischen Ablenksystems für ein korpuskularstrahloptisches Gerät, insbesondere einen Elektronenstrahl-Schreiber, bei dem der durch Ablenkspulen fliessende Strom gemessen und durch Vergleich mit einem Soll-Wert ein Regelsignal zur Nachregelung des Spulenstromes erzeugt wird, dadurch gekennzeichnet, dass bei Sollwertänderungen der Regelung über die Messung des durch die Ablenkspulen fliessenden Stromes ein zweiter Regelkreis dadurch überlagert wird, dass ein der Magnetfeldänderung dB/dt proportionales Signal erzeugt und mit einem der Sollwertänderung dx/dt proportionalen Wert verglichen wird und dass der Vergleichswert als zusätzliches Regelsignal für das Magnetfeld dient.

2. Verfahren zur Regelung eines magnetischen Ablenksystems nach Anspruch 1, dadurch gekennzeichnet, dass das zusätzliche Regelsignal auf die Nachregelung des Spulenstromes I einwirkt.

3. Verfahren zur Regelung eines magnetischen Ablenksystems nach Anspruch 1, dadurch gekennzeichnet, dass das zusätzliche Regelsignal direkt auf das Magnetfeld einwirkt.

4. Vorrichtung zur Durchführung des Verfahrens nach Anspruch 1 oder 2 mit einem aus Spulen bestehenden magnetischen Ablenksystem, einer Regeleinrichtung für den Spulenstrom und einem Sollwertgeber, dadurch gekennzeichnet, dass eine magnetische Messeinrichtung (10) vorgesehen ist, in der das der Feldänderung dB/dt proportionale Signal erzeugt wird, dass der Sollwert (x) zusätzlich einer Differenzierschaltung (11) zugeführt ist und dass die Ausgänge der Magnetfeld-Messeinrichtung (10) und der Differenzierschaltung (11) mit je einem Eingang eines Differenzverstärkers (12) verbunden sind, dessen Ausgang an die Regeleinrichtung (3) für den Spulenstrom angeschlossen ist.

5. Vorrichtung zur Durchführung des Verfahrens nach Anspruch 1 oder 3 mit einem aus Spulen bestehenden magnetischen Ablenksystem, einer Regeleinrichtung für den Spulenstrom und einem Sollwertgeber, dadurch gekennzeichnet, dass eine Magnetfeld-Messeinrichtung (10) vorgesehen ist, in der das der Feldänderung dB/dt proportionale Signal erzeugt wird, dass der Sollwert (x) zusätzlich einer Differenzierschaltung (11) zugeführt ist und dass die Ausgänge der Magnetfeld-Messeinrichtung (10) und der Differenzierschaltung (11) mit je einem Eingang eines Differenzverstärkers (12) verbunden sind, dessen Ausgang an Zusatzspulen (16) im Ablenksystem (1) angeschlossen ist.

**Claims**

1. A process for controlling a magnetic deflection system for an optical corpuscular beam radiation apparatus, in particular an electron beam printer, wherein the current flowing through deflection coils is measured and a control signal for readjusting the coil current produced by comparison with a theoretical value, characterised in that when changes in the theoretical value control the measuring of the current which flows through the deflection coils, a second control circuit is superimposed, to produce a signal proportional to the magnetic field change dB/dt, and compared with a value which is proportional to the theoretical value change dx/dt, and that the comparison value serves as an additional control signal for the magnetic field.

2. A process for controlling a magnetic deflection system as claimed in Claim 1, characterised in that the additional control signal influences the readjustment of the coil current I.

3. A process for controlling a magnetic deflection system as claimed in Claim 1, characterised in that the additional control signal directly influences the magnetic field.

4. A device for implementing the process as claimed in Claim 1 or 2 comprising a magnetic deflection system, which consists of coils, a control device for the coil current and a theoretical value generator, characterised in that there is provided a magnetic measuring device (10), in which the signal proportional to the field change dB/dt is produced, that the theoretical value (x) is additionally fed to a differentiating circuit (11), and that the outputs of the magnetic field measuring device (10) and of the differentiating circuit (11) are each connected to an input of a differential amplifier (12), whose output is connected to the control device (3) for the coil current.

5. A device for implementing the process as claimed in Claim 1 or 3 comprising a magnetic deflection system, which consists of coils, a control device for the coil current and a theoretical value generator, characterised in that there is provided a magnetic field measuring device (10), wherein the signal proportional to the field change dB/dt is produced, that the theoretical value (x) is additionally fed to a differentiating circuit (11), and that the outputs of the magnetic field measuring device (10) and of the differentiating circuit (11) are each connected to an input of a differential amplifier (12), whose output is connected to additional coils (16) in the deflection system (1).

## Revendications

1. Procédé pour régler un système de déviation magnétique pour un appareil optique à faisceau corpusculaire, notamment un appareil traceur à faisceau électronique, dans lequel le courant circulant à travers des bobines de déviation est mesuré et un signal de réglage pour le réajustement du courant des bobines est produit par compensation avec une valeur de consigne, caractérisé par le fait que lors de variations de la valeur de consigne, un second circuit de réglage est superposé au réglage par l'intermédiaire de la mesure du courant circulant à travers les bobines de déviation grâce au fait qu'un signal proportionnel à la variation de champ magnétique dB/dt est produit et comparé à une valeur proportionnelle à la variation de la valeur de consigne dx/dt, et que le résultat de comparaison sert de signal de réglage supplémentaire pour le champ magnétique.

2. Procédé pour régler un système de déviation magnétique suivant la revendication 1, caractérisé par le fait que le signal de réglage supplémentaire agit sur le réajustement du courant I des bobines.

3. Procédé pour régler un système de déviation magnétique suivant la revendication 1, caractérisé par le fait que le signal de réglage supplémentaire agit directement sur le champ magnétique.

4. Dispositif pour la mise en œuvre du procédé suivant la revendication 1 ou 2, comportant un système de déviation magnétique constitué par des bobines, un dispositif de réglage pour le courant des bobines et un générateur de valeur de consigne, caractérisé par le fait qu'il est prévu un dispositif de mesure magnétique (10) dans lequel est produit le signal proportionnel à la variation de champ dB/dt, que la valeur de consigne (x) est appliquée en outre à un circuit de différentiation (11), et que les sorties du dispositif de mesure (10) du champ magnétique et du circuit de différentiation (11) sont reliées à une entrée respective d'un amplificateur différentiel (12) dont la sortie est raccordée au dispositif de réglage (3) pour le courant des bobines.

5. Dispositif pour la mise en œuvre du procédé suivant la revendication 1 ou 3, comportant un système de déviation magnétique constitué par des bobines, un dispositif de réglage pour le courant des bobines et un générateur de valeur de consigne, caractérisé par le fait qu'il est prévu un dispositif de mesure (10) du champ magnétique dans lequel est produit le signal proportionnel à la variation de champ dB/dt, que la valeur de consigne (x) est appliquée en outre à un circuit de différentiation (11), et que les sorties du dispositif de mesure (10) du champ magnétique et du circuit de différentiation (11) sont reliées à une entrée respective d'un amplificateur différentiel (12) dont la sortie est raccordée à des bobines supplémentaires (16) dans le système de déviation (1).